# EUROPEAN PATENT APPLICATION

(11) **EP 3 438 732 A1**
(43) Date of publication of application: **06.02.2019**
(21) Application number: 18185023.1
(22) Date of filing: 23.07.2018
(51) Int. Cl.: G02F 1/1333, G02F 1/1362, G02F 1/1335

(54) **DISPLAY PANEL AND ELECTRONIC DEVICE**

(30) Priority: 31.07.2017 CN 201720949175 U; 31.07.2017 CN 201710646397
(71) Applicant: Guangdong Oppo Mobile Telecommunications Corp., Ltd, Dongguan, Guangdong 523860 (CN)
(72) Inventor: ZENG, Yuanqing, Guangdong, 523860 (CN)
(74) Representative: Romano, Giuseppe

(57) **Abstract**

The present disclosure relates to a display panel and an electronic device. The display panel includes a first base plate and a second base plate opposite to each other. The first base plate includes a first substrate, a data line, a scanning line and a first transparent region. The first transparent region is provided in the first substrate. The first substrate is not provided with the data line and the scanning line at the first transparent region. The second base plate includes a second substrate, a color resistance and a second transparent region. The second transparent region is provided in the second substrate. The second substrate is not provided with the color resistance at the second transparent region. The first and second transparent regions are arranged oppositely and constitute a further transparent region, and the further transparent region is configured to be passed through by a light signal.

## Description

### FIELD

The present disclosure relates to a technical field of electronic devices, more particularly to a display panel and an electronic device.

### BACKGROUND

A screen-to-body ratio of an electronic device, such as a mobile phone, a tablet computer or other devices, refers to a relative ratio of an area of a screen to an area of a front cover plate. The larger the screen-to-body ratio, the narrower the bezel of the electronic device, such that the area of the screen can be improved on the promise that the area of the electronic device is constant.

In the mobile phone of the related art, the frequently used front-mounted components, such as a front camera and a photoelectric sensor, are usually provided at a top of a front surface of the mobile phone to form a non-display area, thereby decreasing the screen-to-body ratio of the mobile phone.

### SUMMARY

Embodiments of the present disclosure provide a display panel and an electronic device, so as to improve a screen-to-body ratio of the electronic device.

In a first aspect, embodiments of the present disclosure provide a display panel. The display panel includes a first base plate and a second base plate arranged opposite to the first base plate. The first base plate includes a first substrate, a data line, a scanning line and a first transparent region, and the first base plate is not provided with the data line and the scanning line at the first transparent region. The second base plate includes a second substrate, a color resistance and a second transparent region, and the second base plate is not provided with the color resistance at the second transparent region. The first transparent region and the second transparent region are arranged opposite to each other and constitute a further transparent region, and the further transparent region is configured to be passed through by a light signal.

In some embodiments, the data line and the scanning line adjacent to the first transparent region are arranged around an edge of the first transparent region.

In some embodiments, the color resistance adjacent to the second transparent region is arranged around an edge of the second transparent region.

In some embodiments, a plurality of color resistances are provided, the second base plate further includes a black matrix provided to the second substrate, the black matrix is arranged among the color resistances, and the black matrix adjacent to the second transparent region is arranged around the edge of the second transparent region.

In some embodiments, the first transparent region and the second transparent region are superposed.

In some embodiments, the first base plate includes a left driving circuit for the scanning line, a right driving circuit for the scanning line and a driving circuit for the data line, the left driving circuit for the scanning line, the right driving circuit for the scanning line and the driving circuit for the data line are provided to the first substrate, and the left driving circuit for the scanning line and the right driving circuit for the scanning line are arranged symmetrically.

In some embodiments, the display panel further includes a sealant provided between the first base plate and the second base plate.

In some embodiments, the first transparent region includes a first through hole formed in the first substrate, and the first through hole is configured to be passed through by the light signal.

In some embodiments, the first transparent region includes a portion of the first substrate, and the portion of the first substrate is configured to be passed through by the light signal.

In some embodiments, the second transparent region includes a second through hole formed in the first substrate, and the second through hole is configured to be passed through by the light signal.

In some embodiments, the second transparent region includes a portion of the second substrate, and the portion of the second substrate is configured to be passed through by the light signal.

In a second aspect, embodiments of the present disclosure provide an electronic device. The electronic device includes a display panel. The display panel includes a first base plate and a second base plate arranged opposite to the first base plate. The first base plate includes a first substrate, a data line, a scanning line and a first transparent region. The first transparent region is provided in the first substrate, and the data line and the scanning line are provided to a portion of the first substrate where the first transparent region is not arranged. The second base plate includes a second substrate, a color resistance and a second transparent region. The second transparent region is provided in the second substrate, and the color resistance is provided to a portion of the second substrate where the second transparent region is not arranged. The first transparent region is aligned with the second transparent region to constitute a further transparent region, and the further transparent region is configured to be passed through by a light signal. The electronic device further includes a component facing the further transparent region and configured to receive the light signal.

In some embodiments, the component includes a front camera facing the further transparent region.

In some embodiments, the component includes a photoelectric sensor facing the further transparent region.

In some embodiments, the component is embedded in the further transparent region of the display panel or arranged behind the further transparent region of the display panel.

### BRIEF DESCRIPTION OF THE DRAWINGS

To describe technical solutions in embodiments of the present disclosure more clearly, the following will briefly introduce the accompanying drawings required for the description of the embodiments. Obviously, the accompanying drawings described below show some embodiments of the present disclosure, and those skilled in the art can obtain other drawings based on these drawings without paying creative efforts.
Fig. 1 is a schematic view of an electronic device according to an embodiment of the present disclosure.
Fig. 2 is a front view of the electronic device illustrated in Fig. 1.
Fig. 3 is a schematic view of a display panel according to an embodiment of the present disclosure.
Fig. 4 is a sectional view of the display panel illustrated in Fig. 3 taken along direction A-A.
Fig. 5 is another schematic view of a display panel according to an embodiment of the present disclosure.
Fig. 6 is a sectional view of the display panel illustrated in Fig. 5 taken along direction B-B.
Fig. 7 is a schematic view of a first base plate according to an embodiment of the present disclosure.
Fig. 8 is an enlarged view of portion C of the first base plate illustrated in Fig. 7.
Fig. 9 is another schematic view of a first base plate according to an embodiment of the present disclosure.
Fig. 10 is a schematic view of a first substrate according to an embodiment of the present disclosure.
Fig. 11 is a schematic view of a second base plate according to an embodiment of the present disclosure.
Fig. 12 is another schematic view of a second base plate according to an embodiment of the present disclosure.
Fig. 13 is a schematic view of a second substrate according to an embodiment of the present disclosure.

### DETAILED DESCRIPTION

Technical solutions in embodiments of the present disclosure will be clearly and completely described below with reference to the accompanying drawings in the embodiments of the present disclosure. Obviously, the embodiments described herein are only a part but not all of the embodiments of the present application. Based on the embodiments of the present disclosure, all other embodiments obtained by those skilled in the art without paying creative efforts, fall into the protection scope of the present application.

In the specification, it is to be understood that terms such as "central," "longitudinal," "lateral," "length," "width," "thickness," "upper," "lower," "front," "rear," "left," "right," "vertical," "horizontal," "top," "bottom," "inner," "outer," "clockwise," and "counterclockwise," should be construed to refer to the orientation as then described or as shown in the drawings under discussion. These relative terms are for convenience of description and do not require that the present disclosure be constructed or operated in a particular orientation. In addition, terms such as "first" and "second" are used herein for purposes of description and are not intended to indicate or imply relative importance or significance and are not intended to implicitly indicate the number of the technical feature mentioned. Thus, features limited by "first" and "second" are intended to indicate or imply including one or more than one these features. In the description of the present disclosure, "a plurality of" means two or more than two, unless specified otherwise.

In the present disclosure, unless specified or limited otherwise, the terms "mounted," "connected," "coupled" and the like are used broadly, and may be, for example, fixed connections, detachable connections, or integral connections; may also be mechanical or electrical connections; may also be direct connections or indirect connections via intervening structures; may also be inner communications of two elements or interaction relationships between two elements. The above terms can be understood by those skilled in the art according to specific situations.

In the description of the present disclosure, a structure in which a first feature is "on" or "beneath" a second feature may include an embodiment in which the first feature directly contacts the second feature, and may also include an embodiment in which an additional feature is formed between the first feature and the second feature so that the first feature does not directly contact the second feature, unless otherwise specified. Furthermore, a first feature "on," "above," or "on top of" a second feature may include an embodiment in which the first feature is right "on," "above," or "on top of" the second feature, and may also include an embodiment in which the first feature is not right "on," "above," or "on top of" the second feature, or just means that the first feature has a sea level elevation larger than the sea level elevation of the second feature. While first feature "beneath," "below," or "on bottom of" a second feature may include an embodiment in which the first feature is right "beneath," "below," or "on bottom of' the second feature, and may also include an embodiment in which the first feature is not right "beneath," "below," or "on bottom of' the second feature, or just means that the first feature has a sea level elevation smaller than the sea level elevation of the second feature.

The following disclosure provides many different embodiments or examples to realize different structures of the present disclosure. To simplify the disclosure of the present disclosure, components and configurations in particular examples are elaborated. Of course, they are illustrative, and are not intended to limit the present disclosure. Moreover, reference numbers and/or letters may be repeated in different examples of the present disclosure for the purpose of simplicity and clarity, which shall not be constructed to indicate the relationships among various embodiments and/or configurations. In addition, the present disclosure provides examples of various specific processes and materials, but applicability of other processes and/or utilization of other materials are conceivable for those skilled in the art.

Embodiments of the present disclosure provide a display panel and an electronic device, which will be described in detail hereinafter, respectively.

In the present embodiment, the description will be conducted from the perspective of the display panel, and the display panel may specifically be provided in the electronic device such as a mobile phone, a personal computer, a tablet computer, a PDA (Personal Digital Assistant), and so on.

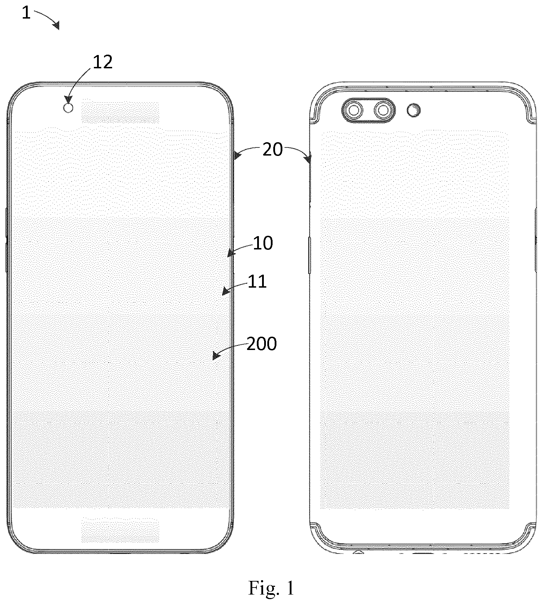

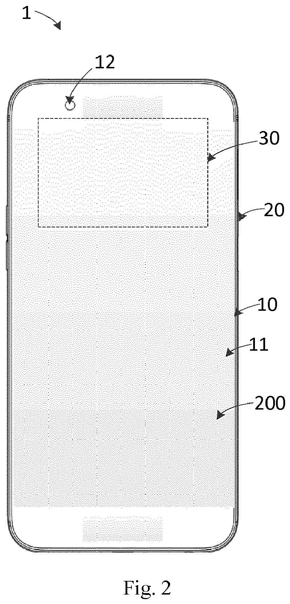

Figs. 1 and 2 are schematic views of the electronic device according to embodiments of the present disclosure. As illustrated in Figs. 1 and 2, the electronic apparatus 1 includes a cover plate 10, a rear cover 20, a printed circuit board 30 and a display panel 200. Although not illustrated in Figs. 1 and 2, the electronic device 1 further includes a battery.

The cover plate 10 is mounted on the display panel 200 to cover the display panel 200. The cover plate 10 may be a transparent glass cover plate. In some embodiments, the cover plate 10 may be the glass cover plate made of materials such as a sapphire. The cover plate 10 includes a display area 11 and a non-display area 12. The display area 11 can be configured to display an image of the electronic device 1 or serve as an area where a user can have a touch control. The non-display area 12 defines an opening for light transmission, or the non-display area 12 may be directly used for light transmission, such as photographing of a front camera, detection of a photoelectric sensor, and so on.

The cover plate 10 may be combined with the rear cover 20 to provide a housing, and the housing has an enclosed space defined by the cover plate 10 and the rear cover 20.

The display panel 200 is disposed under the cover plate 10 and close fitted with the cover plate 10, so as to provide a display surface of the electronic device 1.

The printed circuit board 30 is mounted in the rear cover 20. The printed circuit board 30 may be a mainboard of the electronic device 1. The printed circuit board 30 may be integrated with functional components such as a headphone socket, an interface socket, an antenna, a motor, a microphone, a camera, a light sensor, a receiver, a processor, and so on. Meanwhile, the display panel 200 is electrically coupled to the printed circuit board 30.

The battery is mounted in the rear cover 20, and electrically coupled to the printed circuit board 30 to provide the electronic device 1 with a power source.

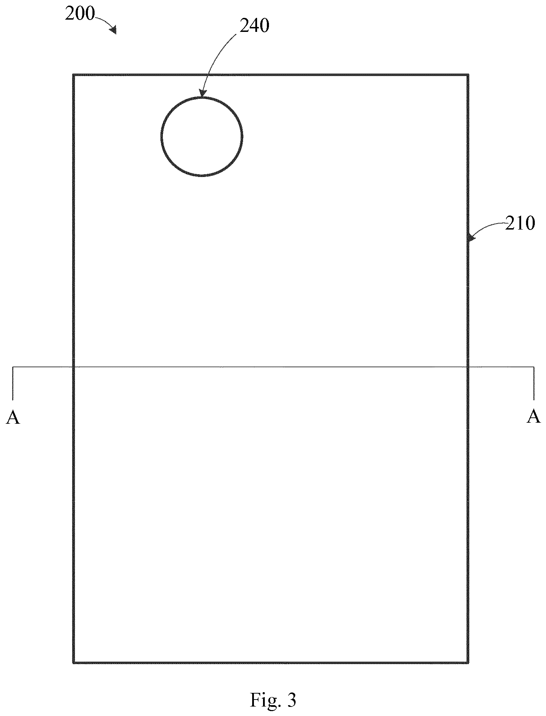

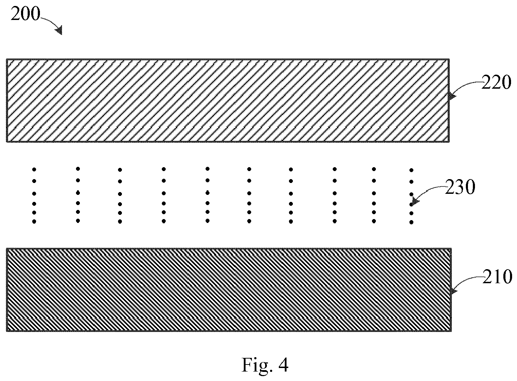

Fig. 3 is a schematic view of a display panel according to an embodiment of the present disclosure, and Fig. 4 is a sectional view of the display panel illustrated in Fig. 3 taken along direction A-A. As illustrated in Figs. 3 and 4, the display panel 200 includes a first base plate 210, a second base plate 220 and a liquid crystal 230.

The first base plate 210 may be an array base plate, the second base plate 220 may be a color resistance base plate, and the liquid crystal 230 is provided between the first base plate 210 and the second base plate 220.

In some embodiments, the display panel 200 is provided with a transparent region, which is defined as a transparent region 240 herein. The transparent region 240 of the display panel 200 may be understood as the non-display area of the display panel 200 herein, and the transparent region 240 corresponds to the non-display area 12 of the cover plate 10, so as to allow a light signal or the like to pass through, thereby achieving transmission of the light signal. It should be noted that the transparent region 240 may run through the entire display panel 200, thereby achieving full transparency.

For example, components such as the front camera, the photoelectric sensor can be provided at the transparent region 240, and the light signal or the like can be transmitted through the transparent region 240 to achieve functions of photographing and sensing. A peripheral area of the transparent region 240 is a portion of the display panel 200 with a display function, i.e. a display area of the display panel 200. When the display panel 200 according to embodiments of the present disclosure is applied to the electronic device such as the mobile phone, the PDA, etc., a full display design can be achieved, through only providing the transparent region 240 in the display panel 200 to accommodate the front camera or the photoelectric sensor. It should be noted that, according to embodiments of the present disclosure, the components such as the front camera, the photoelectric sensor or the like can be directly embedded in the transparent region 240, such that on the basis of achieving the full display, space of the electronic device occupied by the components such as the front camera, the photoelectric sensor or the like can be further reduced, and thus the electronic device can be light and thin.

The photoelectric sensor may include a distance sensor and a photosensitive sensor.

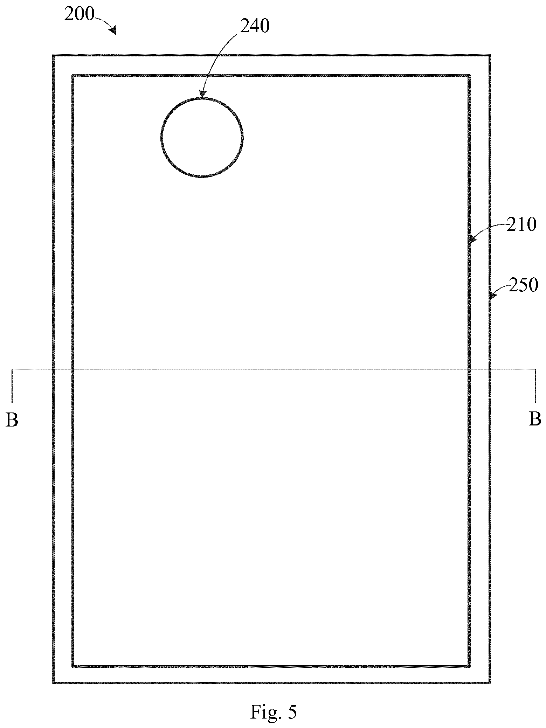

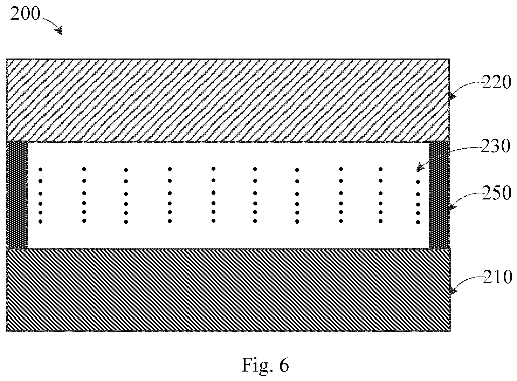

Fig. 5 is another schematic view of the display panel according to an embodiment of the present disclosure, and Fig. 6 is a sectional view of the display panel illustrated in Fig. 5 taken along direction B-B. As illustrated in Fig. 6, the display panel 200 also includes a sealant 250. The sealant 250 is provided between the first base plate 210 and the second base plate 220, and is provided at edges of the first base plate 210 and the second base plate 220 to seal the first base plate 210 and the second base plate 220 and also to shield the edges of the first base plate 210 and the second base plate 220 from the light.

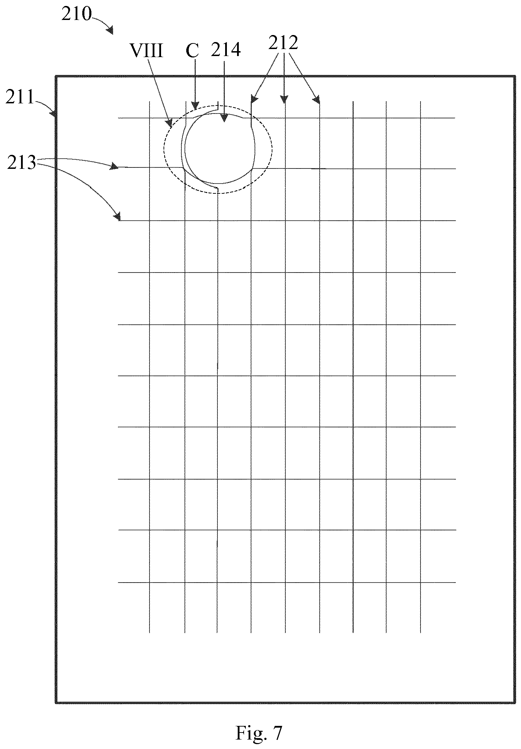

Fig. 7 is a schematic view of the first base plate according to an embodiment of the present disclosure. As illustrated in Fig. 7, the first base plate 210 includes a first substrate 211, a data line 212, a scanning line 213 and a first transparent region 214.

The first substrate 211 is configured to be transparent, and the first substrate 211 may be configured as a glass base sheet, which has good transparency and is easy to arrange. It should be noted that, a type of the first substrate 211 according to embodiments of the present disclosure is not limited to the glass base sheet, and may be another one, such as a flexible base sheet.

A plurality of data lines 212 are provided, formed on the first substrate 211, and evenly arranged in a horizontal direction of the first substrate 211. Each data line 212 extends in a vertical direction of the first substrate 211.

A plurality of scanning lines 213 are provided, formed on the first substrate 211, and evenly arranged in the vertical direction of the first substrate 211. Each scanning line 213 extends in the horizontal direction of the first substrate 211. The data lines 212 and the scanning lines 213 arranged cross each other to define a plurality of pixel units. Each pixel unit may include a pixel electrode and a thin film transistor, and the thin film transistor is configured to control the pixel electrode. The thin film transistor is coupled to the data line 212 and the scanning line 213 separately, so as to control the pixel electrode through signals of the data line 212 and the scanning line 213.

The first transparent region 214 is formed in the first substrate 211 and configured to be passed through by the light signal. The first transparent region 214 is a part of the transparent region 240, that is, the transparent region 240 includes the first transparent region 214. The first substrate 211 is not provided with the pixel unit at the first transparent region 214, and also not provided with the data line 212 and the scanning line 213. The data line 212 and the scanning line 213 adjacent to the first transparent region 214 are arranged around an edge of the first transparent region 214. For example, when the first transparent region 214 has a circular or oval structure, the data line 212 and the scanning line 213 adjacent to the first transparent region 214 are arranged to have an arc shape.

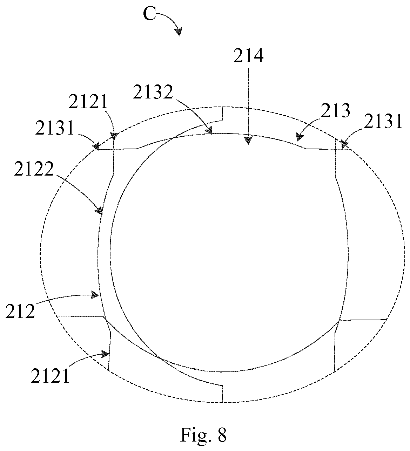

Fig. 8 is an enlarged view of portion C of the first base plate illustrated in Fig. 7. Arrangements of the data line 212 and the scanning line 213 adjacent to the first transparent region 214 are further illustrated in Fig. 8. Only one data line 212 and one scanning line 213 are marked out in Fig. 8. It should be noted that, the scanning line 213 and the data line 212 illustrated in Fig. 8 are merely a part of all, and shall not constitute a limitation on the number of the data lines and the number of the scanning lines.

In some embodiments of the present disclosure, the first transparent region 214 has an irregular circular structure. In other embodiments of the present disclosure, the first transparent region 214 may be configured as a regular circular structure or a regular oval structure.

The one data line 212 is arranged adjacent to the first transparent region 214. The data line 212 includes a first data line segment 2121 and a second data line segment 2122. The first data line segment 2121 is arranged in the vertical direction of the first substrate 211, and is divided into two portions by the second data line segment 2122. The two portions are located at two ends of the second data line segment 2122 and coupled to the two ends of the second data line segment 2122 correspondingly. The second data line segment 2122 has an arc structure, and the arc structure of the second data line segment 2122 is matched with an edge structure of the first transparent region 214 adjacent to the second data line segment 2122.

The one scanning line 213 is arranged adjacent to the first transparent region 214. The scanning line 213 includes a first scanning line segment 2131 and a second scanning line segment 2132. The first scanning line segment 2131 is arranged in the horizontal direction of the first substrate 211, and is divided into two portions by the second scanning line segment 2132. The two portions are located at two ends of the second scanning line segment 2132 and coupled to the two ends of the second scanning line segment 2132 correspondingly. The second scanning line segment 2132 has an arc structure, and the arc structure of the second scanning line segment 2132 is matched with an edge structure of the first transparent region 214 adjacent to the second scanning line segment 2132.

For another example, when the first transparent region 214 has a rectangular or polygonal structure, the data line 212 and the scanning line 213 adjacent to the first transparent region 214 may be arranged around edges of the rectangle or polygon structure. It should be noted that, the above circular, rectangular, polygonal structures are merely specific examples for illustration of the first transparent region 214, and the shape of the first transparent region 214 is not limited to these. It also should be noted that, in embodiments of the present disclosure, the arrangements of the data line 212 and the scanning line 213 at the first transparent region 214 are not limited to these.

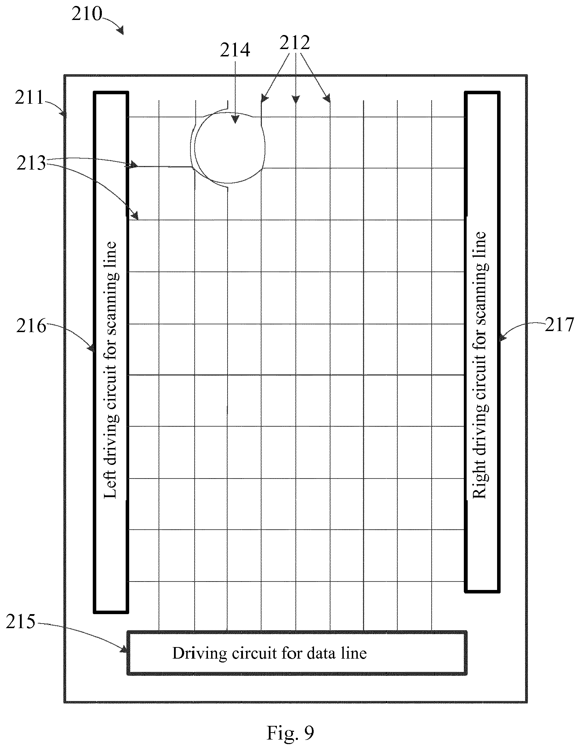

Fig. 9 is another schematic view of the first base plate according to an embodiment of the present disclosure. As illustrated in Fig. 9, the first base plate 210 also includes a driving circuit 215 for the data line, a left driving circuit 216 for the scanning line and a right driving circuit 217 for the scanning line, and the driving circuit 215 for the data line, the left driving circuit 216 for the scanning line and the right driving circuit 217 for the scanning line are provided on the first substrate 211.

The driving circuit 215 for the data line is coupled to the data line 212, and configured to drive the data line 212. The driving circuit 215 for the data line is provided to a bottom of the first substrate 211. It should be noted that, the driving circuit 215 for the data line may also be provided to a top of the first substrate 211.

The left driving circuit 216 for the scanning line and the right driving circuit 217 for the scanning line are coupled to the scanning line 213 separately, and both configured to drive the scanning line 213. The left driving circuit 216 for the scanning line and the right driving circuit 217 for the scanning line are provided at two sides of the first substrate 211 correspondingly, and arranged symmetrically. It should be noted that, in embodiments of the present disclosure, only the left driving circuit 216 for the scanning line may be provided to drive the scanning line 213 or only the right driving circuit 217 for the scanning line may be provided to drive the scanning line 213.

In embodiments of the present disclosure, the first transparent region 214 is formed in the first substrate 211, and the first substrate 211 is not provided with the data line 212, the scanning line 213 as well as other components at the first transparent region 214, thus ensuring transparency and visibility of the first transparent region 214. In some embodiments, the first substrate 211 may define a groove or a through hole therein, such that the data line and the scanning line can be arranged to a side wall surrounding the groove or the through hole.

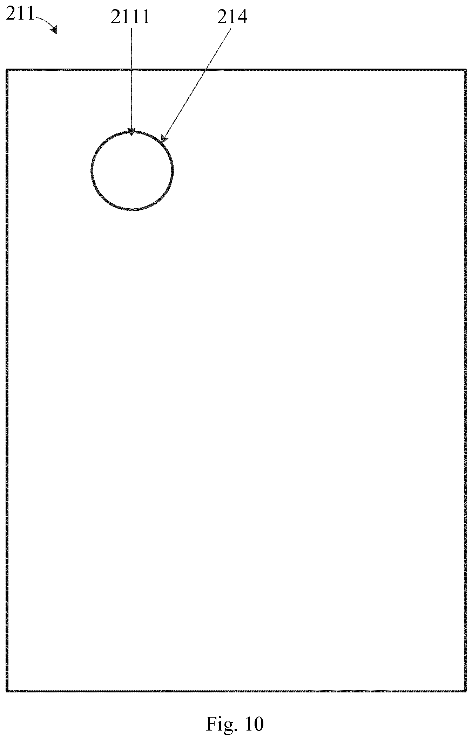

Fig. 10 is a schematic view of the first substrate according to an embodiment of the present disclosure. As illustrated in Fig. 10, the first substrate 211 defines a first through hole 2111 therein, and the first through hole 2111 is communicated with the first transparent region 214, that is, the first transparent region 214 includes the first through hole 2111. Further, the first through hole 2111 is superposed with the first transparent region 214, that is, a cross section of the first through hole 2111 is the same with a cross section of the first transparent region 214. It should be noted that, a specific structure and a specific shape of the first through hole 2111 may be provided according to actual requirements. For example, the first through hole is configured to be smaller than the first transparent region, or the first through hole is configured to be larger than the first transparent region, etc.

The above is the description of the first base plate 210 according to embodiments of the present disclosure. It should be noted that, the first base plate 210 is not limited to the above structures and components, the above content of the first base plate 210 is merely for convenience of describing the embodiments of the present disclosure, but does not limit the entire content of the first base plate 211. In the following, the second base plate will be described in detail.

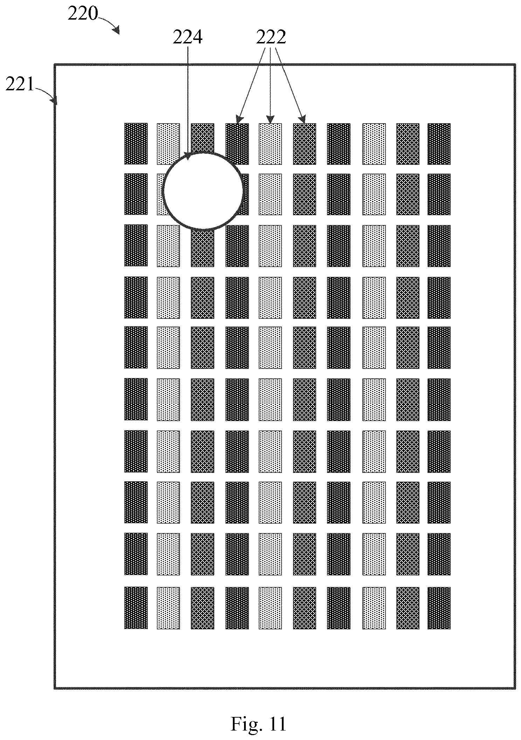

Fig. 11 is a schematic view of the second base plate according to an embodiment of the present disclosure. As illustrated in Fig. 11, the second base plate 220 includes a second substrate 221, a color resistance 222 and a second transparent region 224.

The second substrate 221 may employ a glass base sheet, which has good transparency and is easy to arrange. It should be noted that, a type of the second substrate 221 according to embodiments of the present disclosure is not limited to the glass base sheet, and may be another type, such as a flexible base sheet.

The color resistance 222 is provided on the second substrate 221.

The second transparent region 224 is formed in the second substrate 221 and configured to be passed through by the light signal. The second transparent region 224 is a part of the transparent region 240, that is, the transparent region 240 includes the second transparent region 224. The second substrate 221 is not provided with the color resistance 222 as well as other components or materials at the second transparent region 224, thus ensuring the transparency and visibility of the second transparent region 224. The color resistance 222 adjacent to the second transparent region 224 is arranged around an edge of the second transparent region 224. In some embodiments of the present disclosure, the color resistance 222 close to the second transparent region 224 and even adjacent to the second transparent region 224 is configured to be matched with the edge of the second transparent region 224. For example, the second transparent region 224 has a circular structure, and an edge of the color resistance adjacent to the second transparent region 224 is configured as an arc structure, and may also contact the edge of the second transparent region 224.

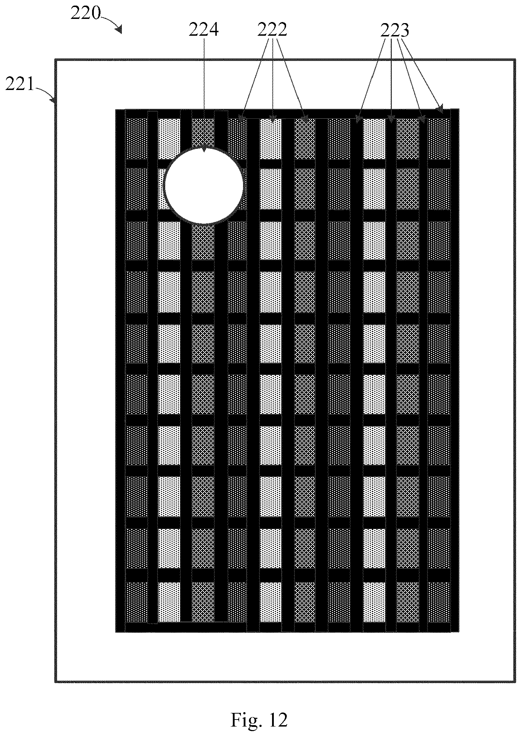

Fig. 12 is another schematic view of a second base plate according to an embodiment of the present disclosure. As illustrated in Fig. 12, the second base plate 220 also includes a black matrix 223. The black matrix 223 is arranged on the second substrate 221 and provided among respective color resistances 222, so as to have a light-shielding effect. The black matrix 223 adjacent to the second transparent region 224 is arranged around the edge of the second transparent region 224. In some embodiments of the present disclosure, the black matrix 223 adjacent to the second transparent region 224 is configured to be matched with the edge of the second transparent region 224. For example, the second transparent region 224 has the circular structure, and the edge of the black matrix 223 adjacent to the second transparent region 224 is configured as the arc structure, and may also contact the edge of the second transparent region 224.

It should be noted that, the second transparent region 224 may also be rectangular, polygonal, irregularly circular, oval, and so on.

In embodiments of the present disclosure, the second transparent region 224 is formed in the second substrate 221, and the second substrate 221 is not provided with other parts or components at the second transparent region 224, thus ensuring the transparency and visibility of the second transparent region 224. In some embodiments, the second substrate 221 may define a groove or a through hole therein, such that the components can be embedded in the groove or the through hole.

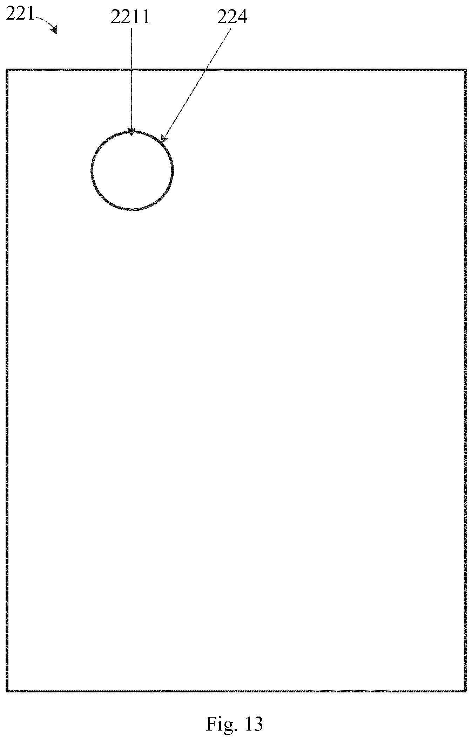

Fig. 13 is a schematic view of the second substrate according to an embodiment of the present disclosure. As illustrated in Fig. 13, the second substrate 221 defines a second through hole 2211, and the second through hole 2211 is communicated with the second transparent region 224, that is, the second transparent region 224 includes the second through hole 2211. Further, the second through hole 2211 is superposed with the second transparent region 224, that is, a cross section of the second through hole 2211 is the same with a cross section of the second transparent region 224. It should be noted that, a specific structure and a specific shape of the second through hole 2211 may be provided according to actual requirements. For example, the second through hole is configured to be smaller than the second transparent region, or the second through hole is configured to be larger than the second transparent region, etc.

The above is the description of the second base plate 220 according to embodiments of the present disclosure. It should be noted that, the second base plate 220 is not limited to the above structures and components, the above content of the second base plate 220 is merely for convenience of describing the embodiments of the present disclosure, but does not limit the entire content of the second base plate 220.

In some embodiments, the first transparent region 214 and the second transparent region 224 are arranged opposite to each other without a shelter between the first transparent region 214 and the second transparent region 224, so as to provide the transparent region 240, and thus the light signal or the like can pass therethrough.

In some embodiments, the shape of the first transparent region 214 is the same with the shape of the second transparent region 224. For example, the first transparent region 214 has a circular structure, and the second transparent region 224 also has a circular structure.

In some embodiments, an area of the first transparent region 214 is the same with an area of the second transparent region 224, that is, the first transparent region 214 and the second transparent region 224 are superposed. For example, the first transparent region 214 has the circular structure, the second transparent region 224 also has the circular structure, and circular areas of the two circular structures are identical. The area of the first transparent region 214 and the area of the second transparent region 224 may be sections or cross sections parallel to the display panel.

It should be noted that, area configurations of the first transparent region 214 and the second transparent region 224 are not limited to this. For example, the area of the first transparent region 214 may be larger than the area of the second transparent region 224. In some embodiments of the present disclosure, a surface of the first transparent region 214 is larger than a surface of the second transparent region 224. In other words, the circular structure of the second transparent region 224 is located within the circular structure of the first transparent region 214 in terms of space.

It can be seen from the above descriptions, the transparent region 240 according to embodiments of the present disclosure may include an enclosed space, for example, constituted by the first transparent region 214 of the enclosed first base plate 210 and the second transparent region 224 of the enclosed second base plate 220. The first transparent region 214 may include a portion of the first substrate 211, and the portion of the first substrate 211 corresponding to the first transparent region 214 is not provided with other parts and components. The second transparent region 224 may include a portion of the second substrate 221, and the portion of the second substrate 221 corresponding to the second transparent region 224 is not provided with other parts and components. Therefore, other components can be provided at the second substrate 221 and fitted therewith, so as to allow the light signal or the like to pass through the transparent region 240.

The transparent region 240 according to embodiments of the present disclosure may also include an unenclosed space. The unenclosed space mentioned herein specifically indicates that the first substrate 211 defines the first through hole 2111 at the first transparent region 214. That is, the first transparent region 214 includes the first through hole 2111, and the first through hole 2111 is communicated with a space inside the first substrate 211 and the second transparent region 224 to form an accommodating space, such that an external component can be embedded in the accommodating space through the first through hole 2111. It should be noted that, the second substrate 221 may further define the second through hole 2211. The second through hole 2211 corresponds to the second transparent region 224, that is, the second transparent region 224 includes the second through hole 2211, and the second through hole 2211 is communicated with the first through hole 2111, such that the transparent region 240 is configured as a through hole penetrating the display panel 200. It should be noted that, the second substrate 221 may also have a recessed structure at a position corresponding to the second transparent region 224 so as to increase a size of the accommodating space.

In some embodiments of the present disclosure, the first transparent region 214 is configured as the first through hole 2111, and the second transparent region 224 is configured as the second through hole 2211. In this case, the first through hole 2111 is aligned and communicated with the second through hole 2211, so as to provide a passage running through the first substrate 211 and the second substrate 221, and thus the light signal or the like can pass through the passage.

Furthermore, the component such as the front camera and the photoelectric sensor can be arranged in the passage, so as to receive the light signal or the like.

The first through hole 2111 and the second through hole 2211 may be provided to have the same size, such that the transparent region 240 is configured as a through hole having a cylindrical shape. It should be noted that, the first through hole 2111 and the second through hole 2211 may also be provided to have different sizes. For example, the first through hole 2111 is larger than the second through hole 2211, such that it is convenient for the components to be embedded in the transparent region 240.

It should be noted that, in embodiments of the present disclosure, only the second through hole 2211 is provided, while the first through hole is not provided.

As can be seen from the above descriptions, the display panel 200 according to embodiments of the present disclosure is provided with the transparent region 240, the components such as the front camera, the photoelectric sensor can be provided at the transparent region 240, and the light signal or the like can be transmitted through the transparent region 240 to achieve functions of photographing and sensing. The peripheral area of the transparent region 240 is the portion of the display panel 200 with the display function, i.e. the display area of the display panel 200. When the display panel 200 according to embodiments of the present disclosure is applied to the electronic device such as the mobile phone, the PDA, etc., the full display design can be achieved by only providing the transparent region 240 on the display panel 200 to accommodate the front camera or the photoelectric sensor. It should be noted that, according to embodiments of the present disclosure, the components such as the front camera, the photoelectric sensor or the like can be directly embedded in the transparent region 240, such that on the basis of achieving the full display, the space of the electronic device occupied by the components such as the front camera, the photoelectric sensor or the like can be further reduced, and the electronic device can be light and thin.

It could be understood by those skilled in the art that, the structures of the electronic device 1 illustrated in Figs. 1 and 2 do not constitute limitations to the electronic device 1. Compared to the illustrated content, the electronic device 1 may include more or less components, or combine some components or have different arrangements of components. The electronic device 1 may further include a processor, a memory, a Bluetooth module, or the like, which will be not further described herein.

The above is the detailed introduction of the display panel and the electronic device according to embodiments of the present disclosure, the principle and the implementation mode of the present disclosure are elaborated by means of specific examples, and the illustration for the above embodiments are merely used to understand the present disclosure. Meanwhile, the specific embodiments and the applied ranges can be changed for those skilled in the art according to the concept of the present disclosure. In general, the content of the present specification should not be construed to limit the present disclosure.

## Claims

1. A display panel (200), comprising a first base plate (210) and a second base plate (220) arranged opposite to the first base plate (210),
wherein the first base plate (210) comprises a first substrate (211), a data line (212), a scanning line (213) and a first transparent region (214), the first substrate (211) is not provided with the data line (212) and the scanning line (213) at the first transparent region (214); and
the second base plate (220) comprises a second substrate (221), a color resistance (222) and a second transparent region (224), the second substrate (221) is not provided with the color resistance (222) at the second transparent region (224),
wherein the first transparent region (214) and the second transparent region (224) are arranged opposite to each other and constitute a further transparent region, and the further transparent region is configured to be passed through by a light signal.

2. The display panel (200) according to claim 1, wherein the data line (212) and the scanning line (213) adjacent to the first transparent region (214) are arranged around an edge of the first transparent region (214).

3. The display panel (200) according to claim 1 or 2, wherein the color resistance (222) adjacent to the second transparent region (224) is arranged around an edge of the second transparent region (224).

4. The display panel (200) according to claim 3, wherein a plurality of color resistances (222) are provided, the second base plate (220) further comprises a black matrix (223) provided to the second substrate (221), the black matrix (223) is arranged among the color resistances (222), and the black matrix (223) adjacent to the second transparent region (224) is arranged around the edge of the second transparent region (224).

5. The display panel (200) according to any one of claims 1-4, wherein the first transparent region (214) and the second transparent region (224) are superposed.

6. The display panel (200) according to any one of claims 1-5, wherein the first base plate (210) comprises a left driving circuit (216) for the scanning line (213), a right driving circuit (217) for the scanning line (213) and a driving circuit (215) for the data line (212), the left driving circuit (216) for the scanning line (213), the right driving circuit (217) for the scanning line (213) and the driving circuit (215) for the data line (212) are provided to the first substrate (211), and the left driving circuit (216) for the scanning line (213) and the right driving circuit (217) for the scanning line (213) are arranged symmetrically.

7. The display panel (200) according to any one of claims 1-6, further comprising a sealant (250) provided between the first base plate (210) and the second base plate (220).

8. The display panel (200) according to any one of claims 1-7, wherein the first transparent region (214) comprises a first through hole (2111) formed in the first substrate (211), and the first through hole (2111) is configured to be passed through by the light signal.

9. The display panel (200) according to any one of claims 1-7, wherein the first transparent region (214) comprises a portion of the first substrate (211), and the portion of the first substrate (211) is configured to be passed through by the light signal.

10. The display panel (200) according to any one of claims 1-9, wherein the second transparent region (224) comprises a second through hole (2211) formed in the first substrate (211), and the second through hole (2211) is configured to be passed through by the light signal.

11. The display panel (200) according to any one of claims 1-9, the second transparent region (224) comprises a portion of the second substrate (221), and the portion of the second substrate (221) is configured to be passed through by the light signal.

12. An electronic device (1), comprising:
a housing;
a display panel provided in the housing, the display panel being configured as a display panel (200) according to any one of claims 1-11; and
a component facing the further transparent region of the display panel (200) and configured to receive the light signal.

13. The electronic device (1) according to claim 12, wherein the component comprises a front camera facing the further transparent region.

14. The electronic device (1) according to claim 12, wherein the component comprises a photoelectric sensor facing the further transparent region.

15. The electronic device (1) according to any one of claims 12-14, wherein the component is embedded in the further transparent region of the display panel (200) or arranged behind the further transparent region of the display panel (200).
